# EUROPÄISCHE PATENTSCHRIFT

(11) **EP 1 590 865 B1**
(45) Veröffentlichungstag und Bekanntmachung des Hinweises auf die Patenterteilung: **10.01.2007**
(21) Anmeldenummer: 03789059.7
(22) Anmeldetag: 19.11.2003
(51) Int. Cl.: H01S 5/183

(54) **VERFAHREN ZUR HERSTELLUNG EINER WELLENLEITERSTRUKTUR IN EINEM OBERFLÄCHENEMITTIERENDEN HALBLEITERLASER UND OBERFLÄCHENEMITTIERENDER HALBLEITERLASER**
METHOD FOR PRODUCING A WAVEGUIDE STRUCTURE IN A SURFACE-EMITTING SEMICONDUCTOR LASER AND SURFACE-EMITTING SEMICONDUCTOR LASER
PROCEDE DE PRODUCTION D'UNE STRUCTURE DE GUIDE D'ONDES DANS UN LASER A SEMI-CONDUCTEURS A EMISSION SUPERFICIELLE ET LASER A SEMI-CONDUCTEURS A EMISSION SUPERFICIELLE

(30) Priorität: 04.02.2003 DE 10304432; 17.04.2003 DE 10317970
(43) Veröffentlichungstag der Anmeldung: 02.11.2005
(73) Patentinhaber: Vertilas GMBH, 85748 Garching (DE)
(72) Erfinder: AMANN, Markus, Christian, 80935 München (DE)
(74) Vertreter: Hössle Kudlek & Partner
(86) Internationale Anmeldenummer: PCT/EP2003/012968
(87) Internationale Veröffentlichungsnummer: WO 2004/070899

(56) Entgegenhaltungen:
- US-A1- 2001 050 934
- CHOQUETTE K D ET AL: "Room temperature continuous wave InGaAsN quantum well vertical-cavity lasers emitting at 1.3 µm" ELECTRONICS LETTERS, IEE STEVENAGE, GB, Bd. 36, Nr. 16, 3. August 2000 (2000-08-03), Seiten 1388-1390, XP006015514 ISSN: 0013-5194
- BOUCART J ET AL: "1-MW CW-RT MONOLITHIC VCSEL AT 1.55 MUM" IEEE PHOTONICS TECHNOLOGY LETTERS, IEEE INC. NEW YORK, US, Bd. 11, Nr. 6, Juni 1999 (1999-06), Seiten 629-631, XP000835419 ISSN: 1041-1135
- SEKIGUCHI S ET AL: "SELECTIVELY FORMED ALAS/INP CURRENT CONFINING TUNNEL JUNCTION FOR GAINASP/INP SURFACE EMITTING LASERS" 1999 11TH. INTERNATIONAL CONFERENCE ON INDIUM PHOSPHIDE AND RELATED MATERIALS. CONFERENCE PROCEEDINGS. IPRM DAVOS, MAY 16 - 20, 1999, INTERNATIONAL CONFERENCE ON INDIUM PHOSPHIDE AND RELATED MATERIALS, NEW YORK, NY : IEEE, US, Bd. CONF. 11, 16. Mai 1999 (1999-05-16), Seiten 211-214, XP000931432 ISBN: 0-7803-5563-6

## Beschreibung

Die Erfindung betrifft ein Verfahren zur Herstellung einer Wellenleiterstruktur in einem oberflächenemittierenden Halbleiterlaser sowie einen solchen Halbleiterlaser.

Oberflächenemittierende Laserdioden (engl.: Vertical-Cavity Surface-Emitting Laser: VCSEL) stellen Halbleiterlaser dar, bei denen die Lichtemission senkrecht zur Oberfläche des Halbleiterchips stattfindet. Verglichen mit konventionellen kantenemittierenden Laserdioden weisen die oberflächenemittierenden Laserdioden mehrere Vorteile auf, wie einen geringen elektrischen Leistungsverbrauch, die Möglichkeit der unmittelbaren Überprüfung der Laserdiode auf dem Wafer, einfache Ankoppelungsmöglichkeiten an eine Glasfaser, longitudinale Einmodenspektren und die Möglichkeit der Zusammenschaltung der oberflächenemittierenden Laserdioden zu einer zweidimensionalen Matrix.

Auf dem Gebiet der Kommunikationstechnik mittels Glasfasern besteht aufgrund der wellenlängenabhängigen Dispersion bzw. Absorption das Bedürfnis nach VCSELs in einem Wellenlängenbereich von ca. 1,3 bis 2 µm, insbesondere um die Wellenlängen von 1,31 µm oder 1,55 µm. Langwellige Laserdioden mit anwendungstauglichen Eigenschaften, speziell für den Wellenlängenbereich oberhalb 1,3 µm, werden bislang aus InP-basierten Verbindungshalbleitern hergestellt. GaAsbasierte VCSELs sind für den kurzwelligeren Bereich < 1,3 µm geeignet. Die folgenden Lösungsansätze wurden bisher verfolgt:

Ein Continuous-Wave VCSEL, der mit einer Leistung von 1 mW bei 1,55 µm emittiert, ist beispielsweise aus einem InP-Substrat mit metamorphen Schichten bzw. Spiegeln aufgebaut (IEEE Photonics Technology Letters, Volume 11, Number 6, June 1999, Seiten 629 bis 631). Laterale Wellenführung wird hier durch Protonenimplantation erzielt.

Ein in einem einzigen epitaktischen. Wachstumsprozess erzeugter VCSEL mit einer Leistung von 0,45 mW bei einer Wellenlänge von 1,5 bis 1,6 µm mit einem metamorphen Spiegel auf der lichtemittierenden Seite ist aus "High Performance 1.6 µm Single-Epitaxy Top-Emitting VCSEL", (Conference on Lasers & Electro-Optics (CLEO) 2000, San Francisco, USA, Post-Deadline Paper CPD 12, pp. 23-24) bekannt. Strom- und Wellenführung wurden hier mittels selektiver Oxidation erzielt.

Ein VCSEL mit Luft-Halbleiterspiegel (InP-Luftspalt-DBRs, für Distributed Bragg Reflectors) ist in IEEE ISLC 2002, Seiten 145 bis 146 vorgeschlagen. Hier ist zwischen der aktiven Zone und dem oberen DBR-Spiegel ein Tunnelkontakt angebracht, wobei durch Unterätzen der Tunnelkontaktschicht eine Strombegrenzung erreicht wird. Der den verbleibenden Tunnelkontaktbereich umgebende Luftspalt dient zur Wellenführung des optischen Feldes. Boucart in «1-mw CW-RT Monolithic VCSEL at 1,5 µm», I3E Photonics Technology Letters, Vol. 12, n°6, June 1999, offenbart ein VCSEL mit einem Tunnelkontakt wobei die Strombegrenzung durch Ionen Implantation erreicht wird.

Weiterhin ist aus der Veröffentlichung zur 26. European Conference on Optical Communication, ECOC 2000, "88°C, Continous-Wave Operation of 1,55 µm Vertical-Cavity Surface-Emitting Lasers", ein VCSEL mit Antimonid-basierten Spiegeln bekannt, bei dem eine unterätzte InGaAs-aktive Zone von zwei n-dotierten InP-Schichten eingeschlossen ist, an die sich AlGaAsSb-DBR-Spiegel anschließen. Die selektive Unterätzung bewirkt hier eine laterale Wellenführung.

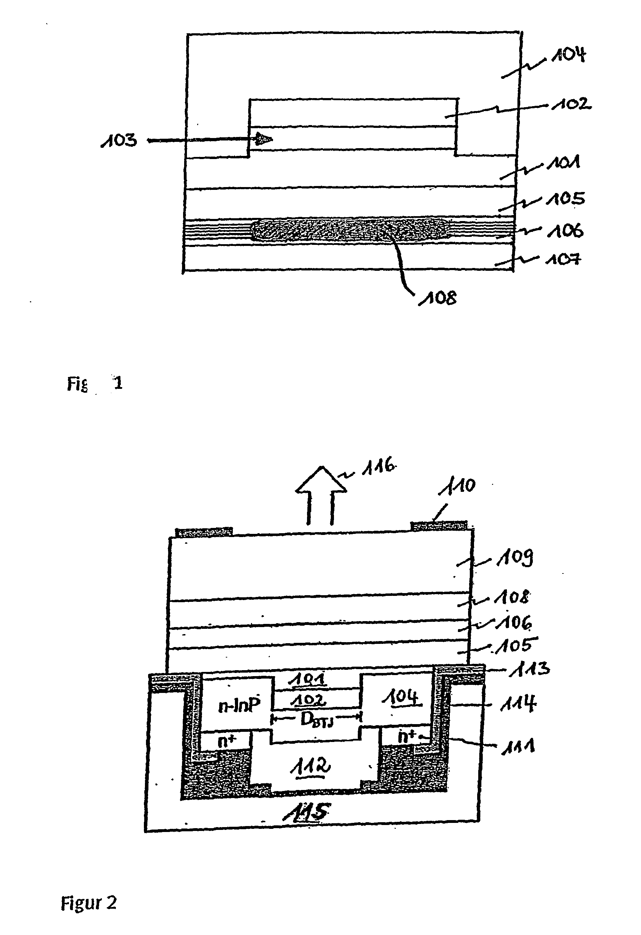

Die besten Eigenschaften hinsichtlich Leistung, Betriebstemperaturbereich, Einmodenleistung und Modulationsbandbreite weisen jedoch VCSELs mit vergrabenen Tunnelkontakten (engl.: Buried Tunnel. Junction, BTJ) auf. Herstellung und Struktur des vergrabenen Tunnelkontakts sollen im Folgenden anhand Figur 1 dargelegt werden. Mittels Molekularstrahlepitaxie (engl.: Molecular Beam Epitaxy, MBE) wird ein hochdotiertes p⁺/n⁺-Schichtenpaar 101, 102 mit geringem Bandabstand hergestellt. Zwischen diesen Schichten bildet sich der eigentliche Tunnelkontakt 103 aus. Durch reaktives Ionenätzen (engl.: Reactive Ion Etching, RIE) wird ein kreisförmiger oder elliptischer Bereich geformt, der im wesentlichen durch die n⁺-dotierte Schicht 102, den Tunnelkontakt 103 sowie eines Teils oder der gesamten p⁺-dotierten Schicht 101 gebildet wird. Dieser Bereich wird in einem zweiten Epitaxiedurchlauf mit n-dotiertem InP (Schicht 104) überwachsen, sodass der Tunnelkontakt 103 "vergraben" ist. Der Kontaktbereich zwischen der überwachsenen Schicht 104 und der p⁺-dotierten Schicht 101 wirkt beim Anlegen einer Spannung als Sperrschicht. Der Strom fließt durch den Tunnelkontakt mit Widerständen von typisch 3 x 10⁻⁶ Ω cm². Hierdurch kann der Stromfluss auf den eigentlichen Bereich der aktiven Zone 108 beschränkt werden. Weiterhin ist die Wärmeerzeugung gering, da der Strom von einer hochohmigen p-dotierten zu einer niederohmigen n-dotierten Schicht fließt.

Die Überwachsung des Tunnelkontakts führt zu leichten Dikkenvariationen, die sich ungünstig auf die laterale Wellenführung auswirken, sodass das Entstehen höherer lateraler Moden insbesondere bei größeren Aperturen erleichtert ist. Für den - insbesondere bei der glasfaseroptischen Kommunikationstechnik geforderten - Einmodenbetrieb können daher nur kleine Aperturen mit entsprechend geringer Laserleistung verwendet werden.

Beispiele und Anwendungen von VCSELs mit vergrabenen Tunnelkontakten finden sich beispielsweise in "Low-threshold index-guided 1,5 µm long wavelength vertical-cavity surface-emitting laser with high efficiency", Applied Physics Letter, Volume 76, Number 16, Seiten 2179 bis 2181 vom 17. April 2000, in "Long Wavelength Buried-Tunnel-Junction Vertical-Cavity Surface-Emitting Lasers", Adv. in Solid State Phys. 41, 75 bis 85, 2001, in "Vertical-cavity surface-emitting laser diodes at 1,55 µm with large output power and high operation temperature", Electronics Letters, Volume 37, Number 21, Seiten 1295 bis 1296 vom 11. Oktober 2001, in "90°C Continuous-Wave Ooperation of 1,83 µm Vertical-Cavity Surface-Emitting Lasers", IEEE Photonics Technology Letters, Volume 12, Number 11, Seiten 1435 bis 1437, November 2000, sowie in "High-Speed modulation up to 10 Gbit/s with 1,55 µm wavelength InGaAlAs VCSELs", Electronics Letters, Volume 38, Number 20, 26. September 2002. Zur lateralen Wellenführung dient hier eine laterale Variation der Resonatorlänge.

Im Folgenden soll ausgehend von dem beschriebenen Aufbau des vergrabenen Tunnelkontakts in Figur 1 kurz die Struktur des in der oben genannten Literatur behandelten InP-basierten VCSEL anhand Figur 2 erläutert werden.

Der vergrabene Tunnelkontakt (BTJ) ist in dieser Struktur umgekehrt angeordnet, sodass die aktive Zone 106 oberhalb des Tunnelkontakts mit dem Durchmesser D_{BTJ} zwischen der p⁺-dotierten Schicht 101 und der n⁺-dotierten Schicht 102 gelegen ist. Die Laserstrahlung tritt in der mit dem Pfeil 116 dargestellten Richtung aus. Die aktive Zone 106 ist von einer p-dotierten Schicht 105 (InAlAs) und von einer n-dotierten Schicht 108 (InAlAs) umgeben. Der vorderseitige Spiegel 109 oberhalb der aktiven Zone 106 besteht aus einem epitaxialen DBR mit etwa 35 Schichtpaaren InGaAlAs/InAlAs, wodurch sich eine Reflektivität von etwa 99,4% ergibt. Der hinterseitige Spiegel 112 besteht aus einem Stapel dielektrischer Schichten als DBR und wird von einer Goldschicht abgeschlossen, wodurch sich eine Reflektivität von nahezu 99,75% ergibt. Eine Isolierschicht 113 vermeidet den direkten Kontakt der n-InP-Schicht 104 mit der meist aus Gold oder Silber bestehenden p-seitigen Kontaktschicht 114 (siehe hierzu DE 101 07 349 A1). 111 bezeichnet die ringförmig strukturierte p-seitige Kontaktschicht.

Die Kombination aus dielektrischem Spiegel 112 und der integrierten Kontaktschicht 114 und Wärmesenke 115 resultiert in einer stark erhöhten Wärmeleitfähigkeit verglichen mit epitaxialen Vielschichtstrukturen. Strom wird über die Kontaktschicht 114 bzw. über die integrierte Wärmesenke 115 und den n-seitigen Kontaktstellen 110 injiziert. Zu weiteren Einzelheiten bezüglich der Herstellung und den Eigenschaften der in Figur 2 dargestellten VCSEL-Typen sei ausdrücklich nochmals auf die oben zitierten Literaturstellen hingewiesen.

Es besteht bei den vorgeschlagenen VCSEL-Dioden, speziell für den Wellenlängenbereich zwischen etwa 1,3 bis 2 µm, ein Bedürfnis, deren laterales Strahlungsprofil durch eine laterale Wellenführung in weiten Bereichen einstellen zu können. Die Herstellung soll auch hier mit der üblichen epitaktischen Überwachsung erfolgen, weshalb sich insbesondere Al-freie InP-basierte VCSELs für Wellenlängen oberhalb 1 µm eignen.

In GaAs-basierten VCSELs, die jedoch nur im Wellenlängenbereich unterhalb etwa 1,3 µm eingesetzt werden können, wird die laterale Wellenführung durch selektiv oxidierte AlAs-Schichten erzeugt (vergl. "Advances in Selective Wet Oxidation of AlGaAs Alloys", in IEEE Journal of Selected Topics in Quantum Electronics, Vol. 3, No. 3, June 1997, pages 916 - 926). Der dort behandelte VCSEL besteht aus GaAs-AlGaAs-Vielschichten, die epitaktisch mittels metallorganischer Dampfphasenepitaxie (MOVPE = Metal Organic Vapor Phase Epitaxy) hergestellt werden. Durch Nassoxidation der AlGaAs-Schichten werden vergrabene Oxidschichten gebildet, die eine unoxidierte Apertur im Zentrum des VCSEL freilassen. Diese Methode konnte bisher noch nicht mit Erfolg auf die InP-basierten VCSELs übertragen werden, da hier AlAs aufgrund der Gitterkonstanten-Fehlanpassung nicht bzw. nur in zu dünnen Schichten aufgebracht werden kann und andere oxidierbare Materialien, wie z. B. AlGaSb, bislang noch keine ausreichende Qualität der Oxidschicht ergaben. Daher wurden bei den langwelligen VCSELs andere Methoden zur lateralen Wellenführung eingesetzt, wie z. B. laterale Variation der Resonatorlänge, selektiv abgeätzte Schichten, Protonenimplantation oder metamorphe AlAs-Schichten, wie oben im Zusammenhang mit den Literaturstellen bereits dargelegt.

Ziel der Erfindung ist es nunmehr, eine insbesondere InP-basierte oberflächenemittierende Laserdiode anzugeben, die sich preiswert und mit hoher Ausbeute fertigen lässt, und deren laterales Strahlungsprofil durch eine laterale Wellenführung in weiten Bereichen eingestellt werden kann. Außerdem soll der laterale Einmodenbetrieb auch bei größeren Aperturen stabil und mit höherer Leistung möglich sein.

Dieses Ziel wird erreicht durch das beanspruchte erfindungsgemäße Verfahren zur Herstellung einer Wellenleiterstruktur in einem oberflächenemittierenden Halbleiterlaser sowie durch den beanspruchten oberflächenemittierenden Halbleiterlaser gemäß Erfindung. Weitere Ausgestaltungen ergeben sich aus den jeweiligen Unteransprüchen und der nachfolgenden Beschreibung.

Das erfindungsgemäße Verfahren zur Herstellung einer Wellenleiterstruktur in einem oberflächenemittierenden Halbleiterlaser mit einer einen pn-Übergang aufweisenden aktiven Zone, umgeben von einer ersten n-dotierten Halbleiterschicht und mindestens einer p-dotierten Halbleiterschicht, und mit einem Tunnelkontakt auf der p-Seite der aktiven Zone, der an eine zweite n-dotierte Halbleiterschicht grenzt, schlägt vor, zunächst in einem ersten epitaktischen Wachstumsprozess auf die mindestens eine p-dotierte Halbleiterschicht eine n-dotierte Sperrschicht aufzubringen, die anschließend zum Teil zur Ausbildung einer Apertur abgetragen wird, um dann in einem zweiten epitaktischen Wachstumsprozess die für den Tunnelkontakt vorgesehene Schicht auf die Sperrschicht sowie die Apertur aufzubringen.

Mit dem erfindungsgemäßen Verfahren ergibt sich demnach folgende epitaktische Struktur außerhalb des Bereichs der Apertur (von unten nach oben): die an die aktive Zone grenzende p-dotierte Halbleiterschicht, die n-dotierte Sperrschicht, der aus einer hoch p- und n-dotierten Halbleiterschicht bestehende Tunnelkontakt sowie die zweite n-dotierte Halbleiterschicht. In dieser überwachsenen Struktur kann der elektrische Strom (Polung oben +,unten -) nur noch im Bereich der Apertur (ohne Sperrschicht) fließen, da außerhalb eine sperrende p-n-p-n-Struktur entstanden ist. Insbesondere ist die Grenzfläche zwischen Sperrschicht und der n-dotierten Halbleiterschicht zwischen Sperrschicht und aktiver Zone gut sperrend. Dadurch wird der laseraktive Bereich innerhalb der aktiven Zone oder laseraktiven Schicht lateral weitgehend durch Form und Größe der Apertur bestimmt. Gleichzeitig kann eine ebenfalls durch die Apertur bestimmte laterale Wellenführung durch entsprechende Wahl der Schichtdicke der Sperrschicht erzeugt werden, die daher lateral exakt auf den laseraktiven Bereich justiert ist (automatische Selbstjustage).

Die erfindungsgemäße Sperrschicht besteht aus einem n-dotierten Material, das vorzugsweise selektiv gegen das Material der angrenzenden p-dotierten Halbleiterschicht ätzbar ist. Beispielsweise besteht diese p-dotierte Halbleiterschicht aus InP und die Sperrschicht aus InGaAsP. In einem Lithographie- und Ätzprozess wird eine runde, elliptische, quadratische, rechteckige oder anderweitig dimensionierte Apertur in der Sperrschicht, durchgehend bis auf die angrenzende p-dotierte Halbleiterschicht erzeugt.

Es ist zu beachten, dass die Tunnelkontaktschicht aufgrund der für den Tunneleffekt erforderlichen hohen Dotierungen und/oder niedrigen Bandabständen im allgemeinen für die Laserstrahlung stark absorbierend wirkt. Deshalb ist es zweckmäßig, innerhalb der Apertur, also im laseraktiven Bereich, die aktive Zone in ein Maximum der vertikalen Intensitätsverteilung der elektrischen Feldstärke zwecks Verstärkungsmaximierung zu legen, während der Tunnelkontakt innerhalb der Apertur in ein Minimum der vertikalen Intensitätsverteilung der elektrischen Feldstärke zwecks Verlustminimierung zu legen ist. Die vertikale Position der Tunnelkontaktschicht außerhalb der Apertur hängt hingegen von der Dicke der Sperrschicht ab und kann z. B. in einem Maximum des Feldes oder in einem Minimum des Feldes liegen. Entsprechend kann die Schichtdicke der Sperrschicht in einem Bereich von nahezu 0 bis zum Abstand eines Minimums bis zum nächsten Maximum des Feldes (= halber Abstand aufeinanderfolgender Maxima oder Minima) gewählt werden. Es kann zweckmäßig sein, die Sperrschicht aus mehreren Einzelschichten zusammenzusetzen.

Wie weiter unten im Zusammenhang mit den Ausführungsbeispielen näher erläutert wird, wird in dem Fall, dass die vertikale Position des Tunnelkontakts außerhalb der Apertur in einem Maximum des Feldes liegt, der Grundmode auf die Apertur eingeengt und höhere Moden werden wegen Ihrer stärkeren Feldausläufer im Außenbereich stark gedämpft und können daher nicht anschwingen. Wird die Dicke der Sperrschicht hingegen sehr klein gewählt, so dass die vertikale Position des Tunnelkontakts außerhalb der Apertur in einem Minimum des Feldes liegt, entsteht keine oder nur eine geringe Wellenführung. Durch Wahl der Schichtdicke der Sperrschicht, insbesondere in dem genannten Bereich, lässt sich somit die laterale Wellenführung und Modenselektion in weiten Bereichen stetig einstellen.

Weitere, insbesondere aus den Unteransprüchen sich ergebende Ausgestaltungen der Erfindung sollen zweckmäßigerweise im folgenden im Zusammenhang mit den nachfolgenden Ausführungsbeispielen erläutert werden. Die Ausgestaltungen der Erfindung sind jedoch keinesfalls auf die behandelten konkreten Ausführungsformen beschränkt.
Figur 1 zeigt schematisch die Struktur eines vergrabenen Tunnelkontakts für einen oberflächenemittierenden Halbleiterlaser gemäß Stand der Technik,
Figur 2 zeigt schematisch die Struktur eines bekannten oberflächenemittierenden Halbleiterlasers mit vergrabenem Tunnelkontakt,
Figur 3 zeigt eine typische epitaktische Ausgangsstruktur für den erfindungsgemäßen oberflächenemittierenden Halbleiterlaser,
Figur 4 zeigt die Ausgangsstruktur von Figur 3 mit in die oberste Schicht eingebrachter Apertur,
Figur 5 zeigt die Struktur aus Figur 4 nach Überwachsen mit weiteren Schichten,
Figur 6 zeigt eine Alternative zur Struktur gemäß Figur 5
Figur 7 zeigt schematisch den fertiggestellten erfindungsgemäßen Halbleiterlaser,
Figur 8 zeigt eine mögliche Schichtanordnung mit Bezug auf den Feldverlauf und
Figur 9 zeigt eine alternative Schichtenpositionierung bezogen auf den Feldverlauf.

Herstellung und Struktur eines bekannten BTJ-VCSEL wurden bereits im Zusammenhang mit den Figuren 1 und 2 in der Beschreibungseinleitung näher erläutert. Im folgenden sollen daher insbesondere die Unterschiede der Herstellung sowie der Struktur des erfindungsgemäßen Halbleiterlasers hervorgehoben werden.

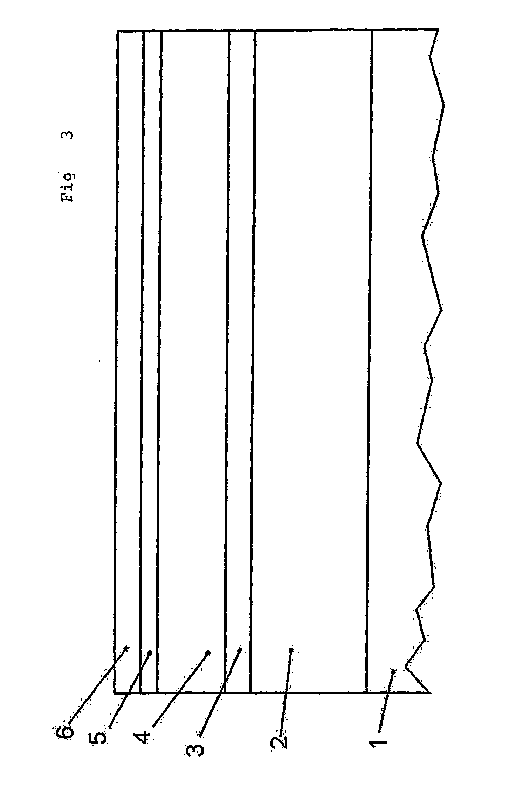

Figur 3 zeigt eine typische epitaktische Ausgangsstruktur für den erfindungsgemäßen WG-VCSEL (WG = Waveguide). Dargestellt ist das Substrat 1, auf das in einem ersten epitaktischen Wachstumsprozess nacheinander als n-dotierte Halbleiterschicht ein epitaktischer Bragg-Spiegel 2, eine aktive Zone 3 und eine p-dotierte Halbleiterschicht 4 aufgebracht wird. Das Substrat besteht in diesem Beispiel aus n-dotiertem InP. Die p-dotierte Halbleiterschicht ist hier eine InP oder InAlAs-Schicht. Optional kann für den Fall, dass die Schicht 4 aus InAlAs besteht, eine weitere p-dotierte InP oder InGaAs-Schicht 5 vorgesehen sein. Auf die p-dotierte Halbleiterschicht wird nunmehr erfindungsgemäß eine n-dotierte Sperrschicht 6 aufgebracht. Die Sperrschicht 6 besteht vorzugsweise aus einem Material, welches sich selektiv gegen das Material der p-dotierten Schicht 5 oder der Schicht 4, falls Schicht 5 fehlt, ätzen lässt. Beispielsweise besteht die angrenzende Schicht 4 bzw. 5 aus InP und die Sperrschicht 6 aus InGaAsP.

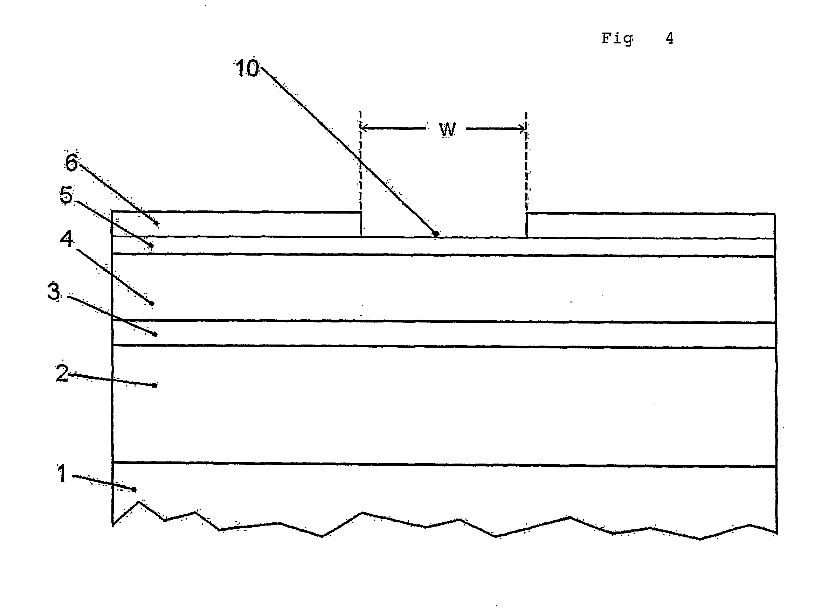

Figur 4 zeigt das Ergebnis des nachfolgenden Lithografie- und Ätzprozesses, währenddessen eine runde, elliptische, quadratische, rechteckige oder anderweitig dimensionierte Apertur 10, die Sperrschicht 6 durchgehend bis auf die angrenzende p-dotierte Halbleiterschicht 5, erzeugt wird. In Figur 4 handelt es sich beispielsweise um eine runde Apertur 10 mit dem Kreisdurchmesser w, wobei der verbleibende kreisringförmige Bereich der Schicht 6 im folgenden mit 6a bezeichnet ist.

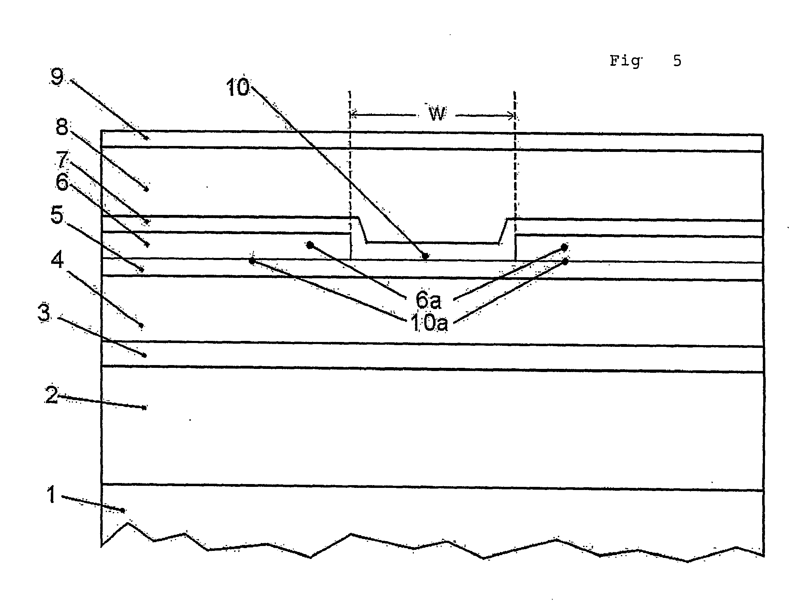

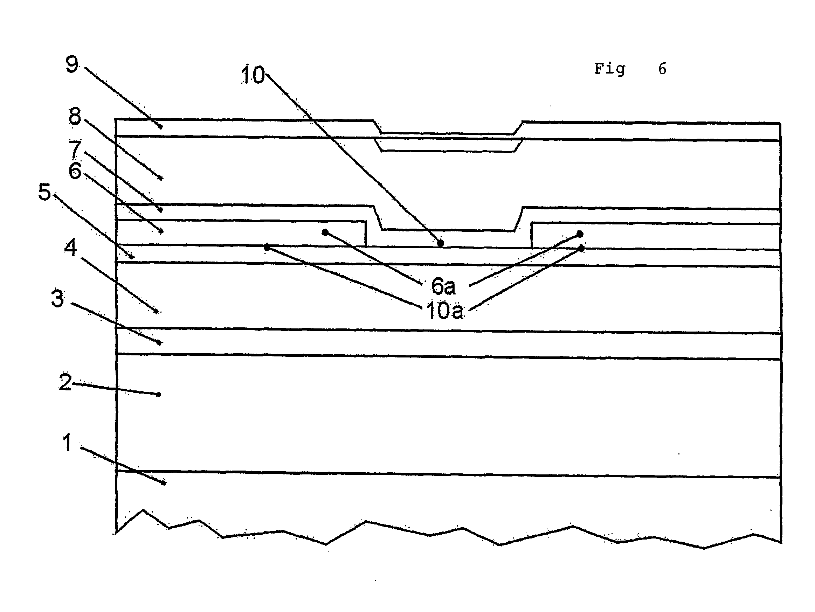

Ähnlich wie bei den bekannten, oben erläuterten BTJ-VCSELs werden in einem zweiten Epitaxieschritt zunächst die für den Tunnelkontakt 7 vorgesehene Schicht, bestehend beispielsweise aus jeweils einer hoch p- und n-dotierten InGaAs-Schicht, eine obere n-dotierte Confinement-Schicht 8, die vorzugsweise aus InP besteht, und eine optionale n-Kontaktschicht 9, bestehend vorzugsweise aus hoch n-dotiertem InGaAs, aufgebracht. Die Figuren 5 und 6 zeigen zwei alternative Ergebnisse, wobei je nach Prozessparametern oder je nach Epitaxieverfahren die laterale Strukturierung der Apertur 10 eingeebnet (Figur 5) oder weitgehend beibehalten (Figur 6) werden kann. Epitaxieverfahren sind beispielsweise MBE (Molecular Beam Epitaxy), CBE (Chemical Beam Epitaxy), MOVPE (Metal Organic Vapour Phase Epitaxy).

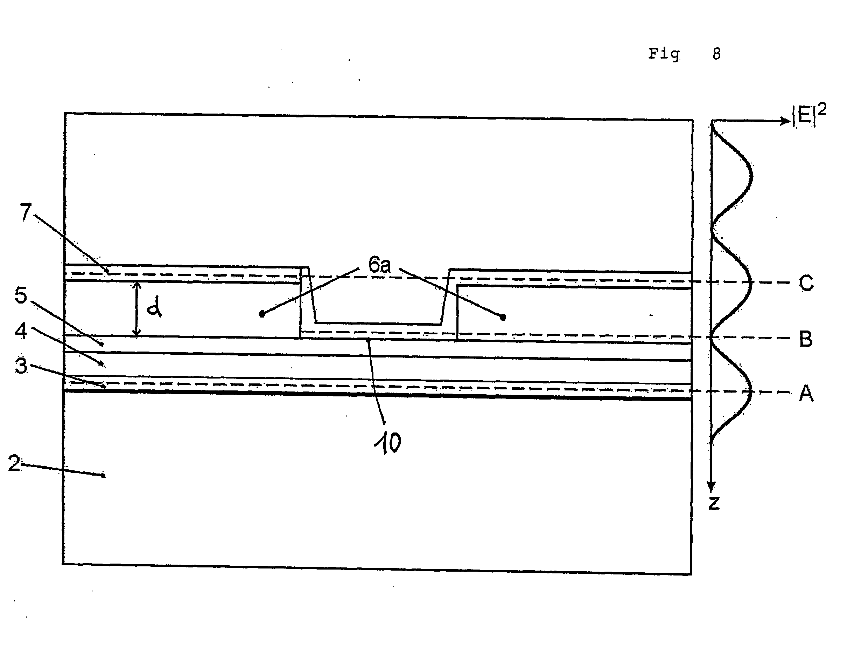

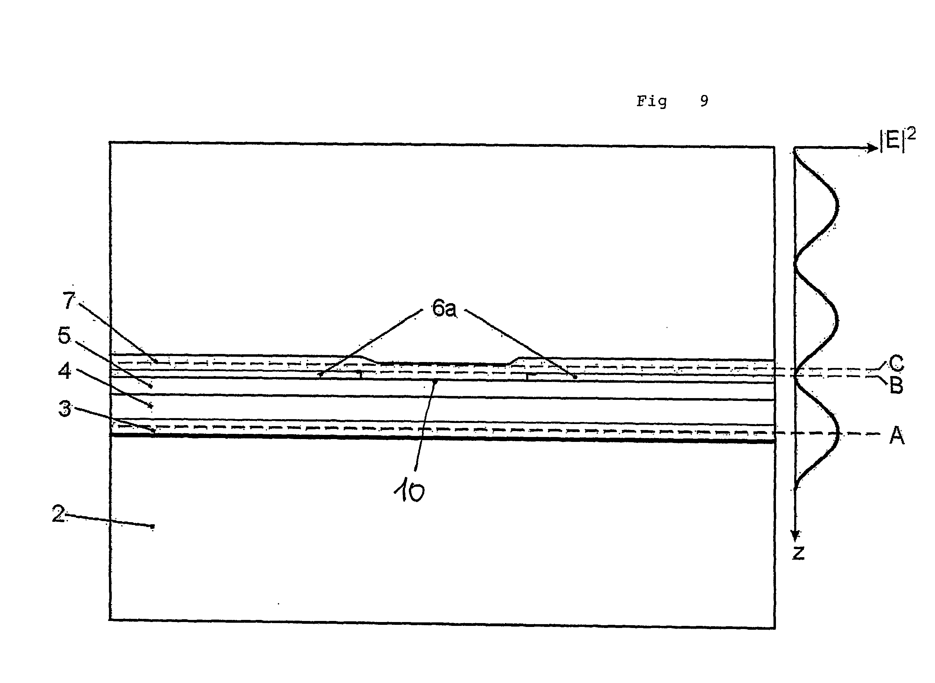

Wie bereits erläutert, kann in der überwachsenen Struktur der elektrische Strom (Polung: oben +, unten -) nunmehr nur noch im Bereich der Apertur 10 fließen, da außerhalb dieser Apertur 10 eine sperrende p-n-p-n-Struktur der Halbleiterschichten 5, 6, 7 und 8 entstanden ist. Insbesondere ist die Grenzfläche 10a zwischen der p-dotierten Halbleiterschicht und der Sperrschicht 6 gut sperrend. Dadurch wird der laseraktive Bereich innerhalb der laseraktiven Schicht 3 lateral weitgehend durch Form und Größe der Apertur 10 bestimmt. Gleichzeitig kann eine ebenfalls durch die Apertur 10 bestimmte laterale Wellenführung durch entsprechende Wahl der Schichtdicke der Sperrschicht 6 erzeugt werden, die daher lateral exakt auf den laseraktiven Bereich justiert ist. Dies sei anhand der Figuren 8 und 9 erläutert:

In Figur 8 beträgt die Schichtdicke d der Sperrschicht 6a etwa gleich dem halben Abstand zweier Minima in der vertikalen Intensitätsverteilung der elektrischen Feldstärke, wie sie am rechten Rand der vergrößert dargestellten Schichtstruktur aufgetragen ist. Die in Figur 8 dargestellte Struktur ermöglicht eine starke Wellenführung. Schwache Wellenführung erhält man mit einer Struktur gemäß Figur 9 bei sehr geringer Schichtdicke d der ringförmigen Sperrschicht 6a.

Es ist zu beachten, dass die Tunnelkontaktschicht 7 aufgrund der für den Tunneleffekt erforderlichen hohen Dotierungen und/oder niedrigen Bandabständen im allgemeinen für die Laserstrahlung stark absorbierend wirkt. In allen Fällen werden innerhalb der Apertur 10, d. h. im laseraktiven Bereich, die aktive Schicht 3 (Schnitt A in Figuren 8 und 9) und der Tunnelkontakt 7 im Bereich der Apertur 10 (Schnitt B in Bildern 8 und 9) in ein Maximum bzw. in ein Minimum gelegt. Die im Maximum liegende aktive Zone erfährt somit eine Verstärkungsmaximierung, während der im Minimum liegende Tunnelkontakt zur Verlustminimierung führt.

Die vertikale Position des Tunnelkontakts 7 außerhalb der Apertur 10 (Schnitt C) hängt hingegen von der Dicke d der Sperrschicht 6a ab und kann zum Beispiel in einem Maximum des Feldes (Bild 8) oder in einem Minimum des Feldes (Bild 9) liegen. Im ersten Fall erfährt der Teil des Laserfeldes, der sich im Außenbereich (außerhalb Apertur 10) befindet, eine starke Dämpfung und/oder eine Variation der effektiven Brechzahl, sofern die Brechzahl der Tunnelkontaktschicht 7 sich von der der Mantelschicht/Confinement-Schicht 8 unterscheidet. Durch den radialen Gradienten der optischen Verstärkung bzw. die Verluste am Rande der Apertur 10 wird der Grundmodus auf die Apertur 10 eingeengt und höhere Moden werden wegen ihrer stärkeren Feldausläufer im Außenbereich stark gedämpft und können daher nicht anschwingen. Die Struktur gemäß Figur 8 erlaubt daher einen Einmoden-Betrieb mit hoher Laserleistung.

Der andere Extremfall der schwachen Wellenführung ist in Figur 9 dargestellt. Wird die Dicke d der Sperrschicht 6a sehr klein gewählt, entsteht keine bzw. nur eine geringe Wellenführung. Die Dämpfung außerhalb der Apertur 10 ist gering und höhere Moden werden weniger stark gedämpft und können anschwingen.

Die Figuren 8 und 9 zeigen, dass durch Wahl der Schichtdicke d der erfindungsgemäßen Sperrschicht 6a sich die laterale Wellenführung und Modensektion im erfindungsgemäßen WG-VCSEL in weiten Bereichen stetig einstellen lassen.

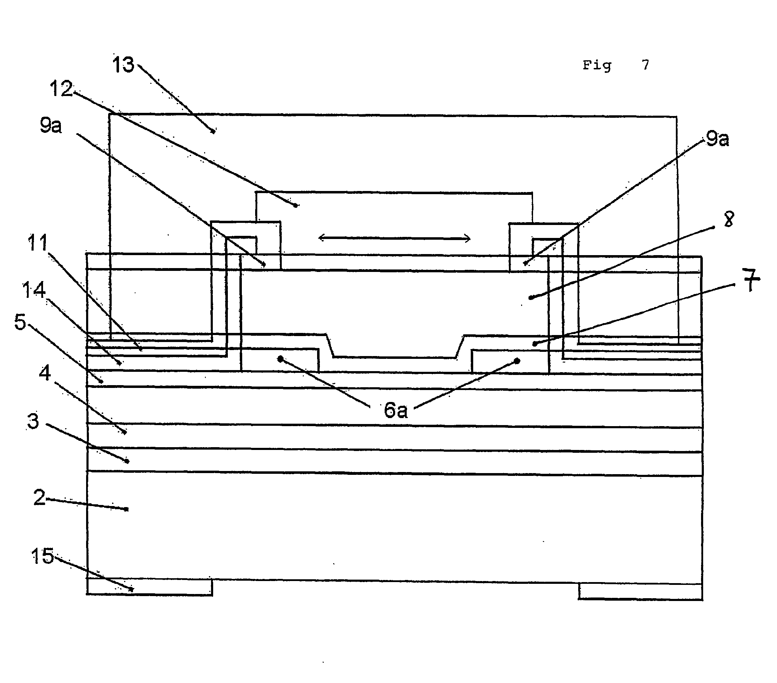

Figur 7 zeigt schließlich die Struktur des fertigen erfindungsgemäßen Halbleiterlasers mit Wellenführung (WG-VCSEL), wobei die Prozessierung dieser Struktur ausgehend von derjenigen in der Figuren 5 und 6 der von den BTJ-VCSELs her bekannten Technik, die in der Beschreibungseinleitung ausführlich behandelt wurde, entspricht. Auf eine detaillierte Beschreibung soll deshalb hier verzichtet werden. Beim fertigen WG-VCSEL wurde das ursprüngliche n-InP-Substrat 1 vollständig entfernt und ein n-seitiger Kontakt 15 aufgebracht. Auf der n-dotierten Confinement-Schicht 8 befindet sich eine ringförmige p-seitige Kontaktschicht 9a, die einen dielektrischen Spiegel 12 einschließt. Der p-seitige Kontakt 11 (z.B. Au/Ti/Pt/Au) ist über eine Isolations- und Passivierungsschicht 14 (z.B. aus Si₃N₄ oder Al₂O₃) von der n-dotierten Confinement-Schicht 8 getrennt. Auf dieser Struktur befindet sich die umgebende integrierte Gold-Wärmesenke 13. Der n-seitige Kontakt 15 besteht beispielsweise aus Ti/Pt. Auf dessen Seite tritt das Laserlicht aus dem Halbleiterlaser aus.

Abschließend sei darauf hingewiesen, dass die aktive Zone 3, die hier als homogene Schicht dargestellt ist, meistens aus einer Schichtenstruktur von beispielsweise 11 dünnen Schichten (5 Quantenfilm und 6 Barrierenschichten) besteht.

Die Erfindung erlaubt die Herstellung eines VCSEL mit Wellenleiterstruktur mit einem stetig einstellbaren Bereich der lateralen Wellenführung und der Modenselektion. Die Einmoden-Leistung ist im Vergleich zu bisherigen Laserdioden erhöht.

## Patentansprüche

1. Verfahren zur Herstellung einer Wellenleiterstruktur in einem oberflächenemittierenden Halbleiterlaser mit einer einen pn-Übergang aufweisenden aktiven Zone (3) umgeben von einer ersten n-dotierten Halbleiterschicht (2) und mindestens einer p-dotierten Halbleiterschicht (4, 5), und mit einem Tunnelkontakt (7) auf der p-Seite der aktiven Zone (3), der an eine zweite n-dotierte Halbleiterschicht (8) grenzt, **dadurch gekennzeichnet dass**
in einem ersten epitaktischen Wachstumsprozess auf die mindestens eine p-dotierte Halbleiterschicht (4, 5) eine n-dotierte Sperrschicht (6, 6a) aufgebracht wird, die anschließend zum Teil zur Ausbildung einer Apertur (10) abgetragen wird, und wobei in einem zweiten epitaktischen Wachstumsprozess die für den Tunnelkontakt (7) vorgesehene Schicht auf die Sperrschicht (6, 6a) sowie die Apertur (10) aufgebracht wird.

2. Verfahren nach Anspruch 1, **dadurch gekennzeichnet, dass** die Schichtdicke (d) der Sperrschicht (6, 6a) in einem Bereich von 0<d≤λ/2 gewählt wird, wobei d die Schichtdicke und λ den Abstand zweier Minima in der vertikalen Intensitätsverteilung der elektrischen Feldstärke darstellt.

3. Verfahren nach Anspruch 1 oder 2, **dadurch gekennzeichnet, dass** als Sperrschicht (6, 6a) ein Material gewählt wird, das selektiv gegen die angrenzende p-dotierte Halbleiterschicht (4, 5) ätzbar ist.

4. Verfahren nach einem der Ansprüche 1 bis 3, **dadurch gekennzeichnet, dass** die Sperrschicht (6, 6a) aus InGaAsP oder InGaAs und die angrenzende p-dotierte Halbleiterschicht (3, 5) aus InP hergestellt wird.

5. Verfahren nach einem der Ansprüche 1 bis 4, **dadurch gekennzeichnet, dass** die aktive Zone (3) in einem Maximum der vertikalen Intensitätsverteilung der elektrischen Feldstärke und der Tunnelkontakt (7) im Bereich der Apertur (10) in einem Minimum der vertikalen Intensitätsverteilung der elektrischen Feldstärke angeordnet wird.

6. Verfahren nach einem der Ansprüche 1 bis 5, **dadurch gekennzeichnet, dass** der Tunnelkontakt (7) außerhalb des Bereichs der Apertur (10) in einem Maximum der vertikalen Intensitätsverteilung der elektrischen Feldstärke angeordnet wird.

7. Oberflächenemittierender Halbleiterlaser, der eine einen pn-Übergang aufweisende aktive Zone (3), umgeben von einer ersten n-dotierten Halbleiterschicht (2) und mindestens einer p-dotierten Halbleiterschicht (4, 5) aufweist, sowie einen Tunnelkontakt (7) auf der p-Seite der aktiven Zone (3), der an eine zweite n-dotierte Halbleiterschicht (8) grenzt, **dadurch gekennzeichnet dass** mit Ausnahme eines eine Apertur (10) bildenden Bereiches zwischen der für den Tunnelkontakt (7) vorgesehenen Schicht und der mindestens einen p-dotierten Halbleiterschicht (4, 5) eine n-dotierte Sperrschicht (6, 6a) vorgesehen ist.

8. Halbleiterlaser nach Anspruch 7, **dadurch gekennzeichnet, dass** im Bereich der Apertur (10) der Tunnelkontakt (7) direkt auf die p-dotierte Halbleiterschicht (4, 5) aufgebracht ist.

9. Halbleiterlaser nach Anspruch 7 oder 8, **dadurch gekennzeichnet, dass** die Schichtdicke (d) der Sperrschicht (6, 6a) 0<d<λ/2 beträgt, wobei d die Schichtdicke und λ den Abstand zweier Minima der vertikalen Intensitätsverteilung der elektrischen Feldstärke darstellt.

10. Halbleiterlaser nach einem der Ansprüche 7 bis 9, **dadurch gekennzeichnet, dass** die Sperrschicht (6, 6a) aus einem Material besteht, das selektiv gegen die angrenzende p-dotierte Halbleiterschicht (4, 5) ätzbar ist.

11. Halbleiterlaser nach einem der Ansprüche 7 bis 10, **dadurch gekennzeichnet, dass** die Sperrschicht aus InGaAs und die angrenzende p-dotierte Halbleiterschicht (4, 5) aus InP besteht.

12. Halbleiterlaser nach einem der Ansprüche 7 bis 11, **dadurch gekennzeichnet, dass** die aktive Zone (3) in einem Maximum der vertikalen Intensitätsverteilung der elektrischen Feldstärke und der Tunnelkontakt (7) im Bereich der Apertur (10) in einem Minimum der vertikalen Intensitätsverteilung der elektrischen Feldstärke angeordnet ist.

13. Halbleiterlaser nach einem der Ansprüche 7 bis 12, **dadurch gekennzeichnet, dass** der Tunnelkontakt (7) außerhalb des Bereichs der Apertur (10) in einem Maximum der vertikalen Intensitätsverteilung der elektrischen Feldstärke angeordnet ist.

14. Halbleiterlaser nach einem der Ansprüche 7 bis 13, **dadurch gekennzeichnet, dass** sich an die an den Tunnelkontakt (7) angrenzende zweite n-dotierte Halbleiterschicht (8) zumindest zum Teil eine weitere n-dotierte Kontaktschicht (9) anschließt.

15. Halbleiterlaser nach einem der Ansprüche 7 bis 14, **dadurch gekennzeichnet, dass** sich an die an den Tunnelkontakt (7) angrenzende zweite n-dotierte Halbleiterschicht (8) zumindest zum Teil ein dielektrischer Spiegel (12) anschließt.

16. Halbleiterlaser nach einem der Ansprüche 7 bis 15, **dadurch gekennzeichnet, dass** die erste n-dotierte Halbleiterschicht (2) als n-dotierter epitaktischer Bragg-Spiegel ausgebildet ist.

17. Halbleiterlaser nach einem der Ansprüche 7 bis 16, **dadurch gekennzeichnet, dass** als die mindestens eine p-dotierte Halbleiterschicht (4, 5) eine p-dotierte InP- oder InAlAs-Schicht (4) vorgesehen ist.

18. Halbleiterlaser nach einem der Ansprüche 7 bis 17, **dadurch gekennzeichnet, dass** als die mindestens eine p-dotierte Halbleiterschicht (4, 5) eine p-dotierte InAlAs-Schicht (4) und eine p-dotierte InP- oder InGaAs-Schicht (5) vorgesehen ist.

19. Halbleiterlaser nach einem der Ansprüche 7 bis 18, **dadurch gekennzeichnet, dass** die für den Tunnelkontakt (7) vorgesehene Schicht aus jeweils einer hoch p- und n-dotierten InGaAs-Schicht besteht.

20. Halbleiterlaser nach einem der Ansprüche 7 bis 19, **dadurch gekennzeichnet, dass** die an den Tunnelkontakt (7) grenzende zweite n-dotierte Halbleiterschicht aus InP besteht.

21. Halbleiterlaser nach einem der Ansprüche 7 bis 20, **dadurch gekennzeichnet, dass** die Kontaktschicht (9) aus hoch n-dotiertem InGaAs besteht.

## Claims

1. Method for producing a waveguide structure in a surface-emitting semiconductor laser having an active zone (3) comprising a pn transition, said active zone (3) being surrounded by a first n-doped semiconductor layer (2) and at least one p-doped semiconductor layer (4, 5), and a tunnel junction (7) on the p side of the active zone (3) which is adjacent to a second n-doped semiconductor layer (8), **characterized in that** in a first epitaxial growth process an n-doped barrier layer (6, 6a) is applied to the at least one p-doped semiconductor layer (4, 5), and is subsequently removed in part to form an aperture (10), and in a second epitaxial growth process the layer intended for the tunnel junction (7) is applied to the barrier layer (6, 6a) and the aperture (10).

2. Method according to claim 1, **characterised in that** the thickness (d) of the barrier layer (6, 6a) is selected within a range from 0<d<λ/2, where d is the thickness of the layer and λ is the spacing between two minima in the vertical intensity distribution of the electric field strength.

3. Method according to claim 1 or 2, **characterised in that** the material selected as the barrier layer (6, 6a) is one which is selectively etchable against the adjacent p-doped semiconductor layer (4, 5).

4. Method according to any one of claims 1 to 3, **characterised in that** the barrier layer (6, 6a) is made from InGaAsP or InGaAs and the adjacent p-doped semiconductor layer (3, 5) is made from InP.

5. Method according to any one of claims 1 to 4, **characterised in that** the active zone (3) is arranged in a maximum of the vertical intensity distribution of the electric field strength and the tunnel junction (7) in the region of the aperture (10) is arranged in a minimum of the vertical intensity distribution of the electric field strength.

6. Method according to any one of claims 1 to 5, **characterised in that** the tunnel junction (7) is arranged outside the region of the aperture (10) in a maximum of the vertical intensity distribution of the electric field strength.

7. Surface-emitting semiconductor laser which comprises an active zone (3) having a pn transition, said active zone (3) being surrounded by a first n-doped semiconductor layer (2) and at least one p-doped semiconductor (4, 5), and a tunnel junction (7) on the p-side of the active zone (3) which is adjacent to a second n-doped semiconductor layer (8), **characterized in that** with the exception of an area forming an aperture (10), an n-doped barrier layer (6, 6a) is provided between the layer provided for the tunnel junction (7) and the at least one p-doped semiconductor layer (4, 5).

8. Semiconductor laser according to claim 7, **characterised in that** in the region of the aperture (10) the tunnel junction (7) is applied directly to the p-doped semiconductor layer (4, 5).

9. Semiconductor laser according to claims 7 or 8, **characterised in that** the layer thickness (d) of the barrier layer (6, 6a) is 0<d<λ/2, where d is the layer thickness and λ is the distance between two minima of the vertical intensity distribution of the electric field strength.

10. Semiconductor laser according to any one of claims 7 to 9, **characterised in that** the barrier layer (6, 6a) consists of a material which is selectively etchable against the adjacent p-doped semiconductor layer (4, 5).

11. Semiconductor laser according to any one of claims 7 to 10, **characterised in that** the barrier layer consists of InGaAs and the adjacent p-doped semiconductor layer (4, 5) consists of InP.

12. Semiconductor laser according to any one of claims 7 to 11, **characterised in that** the active zone (3) is arranged in a maximum of the vertical intensity distribution of the electric field strength and the tunnel junction (7) in the region of the aperture (10) is arranged in a minimum of the vertical intensity distribution of the electric field strength.

13. Semiconductor laser according to any one of claims 7 to 12, **characterised in that** the tunnel junction (7) outside the area of the aperture (10) is arranged in a maximum of the vertical intensity distribution of the electric field strength.

14. Semiconductor laser according to any one of claims 7 to 13, **characterised in that** another n-doped contact layer (9) at least partially adjoins the second n-doped semiconductor layer (8) adjoining the tunnel junction (7).

15. Semiconductor laser according to any one of claims 7 to 14, **characterised in that** a dielectric mirror (12) at least partially adjoins the second n-doped semiconductor layer (8) adjoining the tunnel junction (7).

16. Semiconductor laser according to any one of claims 7 to 15, **characterised in that** the first n-doped semiconductor layer (2) is provided as an n-doped epitactic Bragg reflector.

17. Semiconductor laser according to any one of claims 7 to 16, **characterised in that** a p-doped InP or InAlAs layer (4) is provided as the at least one p-doped semiconductor layer (4, 5).

18. Semiconductor laser according to any one of claims 7 to 17, **characterised in that** a p-doped InAlAs layer (4) and a p-doped InP or InGaAs layer (5) are provided as the at least one p-doped semiconductor layer (4, 5).

19. Semiconductor laser according to any one of claims 7 to 18, **characterised in that** the layer provided for the tunnel junction (7) consists of a highly p- and n-doped InGaAs layer.

20. Semiconductor laser according to any one of claims 7 to 19, **characterised in that** the second n-doped semiconductor layer adjacent to the tunnel junction (7) consists of InP.

21. Semiconductor laser according to any one of claims 7 to 20, **characterised in that** the contact layer (9) consists of highly n-doped InGaAs.

## Revendications

1. Procédé de production d'une structure de guide d'ondes dans un laser à semi-conducteurs à émission superficielle, comprenant une zone active (3) présentant une transition pn entourée par une première couche semi-conductrice (2) à dopage n et par au moins une couche semi-conductrice (4, 5) à dopage p, et avec un contact tunnel (7) sur le côté p de la zone active (3), qui est adjacent à une seconde couche semi-conductrice (8) à dopage n, **caractérisé en ce que**, dans un premier processus de croissance épitaxique on applique une couche de blocage (6, 6a) à dopage n sur ladite au moins une couche semi-conductrice (4, 5) à dopage p, couche de blocage qui est ensuite partiellement enlevée pour réaliser une ouverture (10), et, dans un second processus de croissance épitaxique, on applique sur la couche de blocage (6, 6a) ainsi que sur l'ouverture (10) la couche prévue pour le contact tunnel (7).

2. Procédé selon la revendication 1, **caractérisé en ce que** l'épaisseur (d) de la couche de blocage (6, 6a) est choisie dans une plage de 0 < d ≤ λ/2, où d représente l'épaisseur de couche et λ représente la distance de deux minima dans la répartition d'intensité verticale de l'intensité de champ électrique.

3. Procédé selon la revendication 1 ou 2, **caractérisé en ce que** l'on choisit comme couche de blocage (6, 6a) un matériau qui peut être attaqué de façon sélective par rapport à la couche semi-conductrice (4, 5) adjacente à dopage p.

4. Procédé selon l'une des revendications 1 à 3, **caractérisé en ce que** la couche de blocage (6, 6a) est réalisée en InGaAsP ou en InGaAs, et la couche semi-conductrice (3, 5) adjacente à dopage p est réalisée en InP.

5. Procédé selon l'une des revendications 1 à 4, **caractérisé en ce que** le la zone active (3) est disposée à un maximum de la répartition d'intensité verticale de l'intensité de champ électrique, et le contact tunnel (7) est disposé dans la région de l'ouverture (10) à un minimum de la répartition d'intensité verticale de l'intensité de champ électrique.

6. Procédé selon l'une des revendications 1 à 5, **caractérisé en ce que** le contact tunnel (7) est disposé à l'extérieur de la région de l'ouverture (10) à un maximum de la répartition d'intensité verticale de l'intensité de champ électrique.

7. Laser à semi-conducteurs à émission superficielle, qui comprend une zone active (3) présentant une transition pn, entourée par une première couche semi-conductrice (2) à dopage n et par au moins une couche semi-conductrice (4, 5) à dopage p, ainsi qu'un contact tunnel (7) sur le côté p de la zone active (3), qui est adjacent à une seconde couche semi-conductrice (8) à dopage n, **caractérisé en ce que**, à l'exception d'une région, formant une ouverture (10), entre la couche prévue pour le contact tunnel (7) et ladite au moins une couche semi-conductrice (4, 5) à dopage p, il est prévu une couche de blocage (6, 6a) à dopage n.

8. Laser à semi-conducteurs selon la revendication 7, **caractérisé en ce que**, dans la région de l'ouverture (10), le contact tunnel (7) est appliqué directement sur la couche semi-conductrice (4, 5) à dopage p.

9. Laser à semi-conducteurs selon la revendication 7 ou 8, **caractérisé en ce que** l'épaisseur (d) de la couche de blocage (6, 6a) est de 0 < d < λ/2, où d représente l'épaisseur de couche et λ représente la distance de deux minima dans la répartition d'intensité verticale de l'intensité de champ électrique.

10. Laser à semi-conducteurs selon l'une des revendications 7 à 9, **caractérisé en ce que** la couche de blocage (6, 6a) est en un matériau qui peut être attaqué de façon sélective par rapport à la couche semi-conductrice (4, 5) adjacente à dopage p.

11. Laser à semi-conducteurs selon l'une des revendications 7 à 10, **caractérisé en ce que** la couche de blocage (6, 6a) est réalisée en InGaAs, et la couche semi-conductrice (4, 5) adjacente à dopage p est réalisée en InP.

12. Laser à semi-conducteurs selon l'une des revendications 7 à 11, **caractérisé en ce que** le la zone active (3) est disposée à un maximum de la répartition d'intensité verticale de l'intensité de champ électrique, et le contact tunnel (7) est disposé dans la région de l'ouverture (10) à un minimum de la répartition d'intensité verticale de l'intensité de champ électrique.

13. Laser à semi-conducteurs selon l'une des revendications 7 à 12, **caractérisé en ce que** le contact tunnel (7) est disposé à l'extérieur de la région de l'ouverture (10) à un maximum de la répartition d'intensité verticale de l'intensité de champ électrique.

14. Laser à semi-conducteurs selon l'une des revendications 7 à 13, **caractérisé en ce qu'**une autre couche de contact (9) à dopage n fait suite au moins en partie à la seconde couche semi-conductrice (8) à dopage n adjacente au contact tunnel (7).

15. Laser à semi-conducteurs selon l'une des revendications 7 à 14, **caractérisé en ce qu'**un miroir diélectrique (12) fait suite au moins en partie à la seconde couche semi-conductrice (8) à dopage n adjacente au contact tunnel (7).

16. Laser à semi-conducteurs selon l'une des revendications 7 à 15, **caractérisé en ce que** la première couche semi-conductrice (2) à dopage n est réalisée sous la forme d'un miroir de Bragg épitaxique à dopage n.

17. Laser à semi-conducteurs selon l'une des revendications 7 à 16, **caractérisé en ce qu'**il est prévu une couche de InP ou InAlAs (4) à dopage p pour former ladite au moins une couche semi-conductrice (4, 5) à dopage p.

18. Laser à semi-conducteurs selon l'une des revendications 7 à 17, **caractérisé en ce qu'**il est prévu une couche de InAlAs (4) à dopage p et une couche de InP ou InGaAs (5) à dopage p pour former ladite au moins une couche semi-conductrice (4, 5) à dopage p.

19. Laser à semi-conducteurs selon l'une des revendications 7 à 18, **caractérisé en ce que** la couche prévue pour le contact tunnel (7) est constituée respectivement d'une couche de InGaAs fortement dopée en p et d'une couche de InGaAs fortement dopée en n.

20. Laser à semi-conducteurs selon l'une des revendications 7 à 19, **caractérisé en ce que** la seconde couche semi-conductrice à dopage n adjacente au contact tunnel (7) est réalisée en InP.

21. Laser à semi-conducteurs selon l'une des revendications 7 à 20, **caractérisé en ce que** la couche de contact (9) est réalisée en InGaAs fortement dopé en n.
